# EUROPEAN PATENT APPLICATION

(11) **EP 4 503 114 A1**
(43) Date of publication of application: **05.02.2025**
(21) Application number: 23780746.6
(22) Date of filing: 29.03.2023
(51) Int. Cl.: H01L 23/13

(54) **CERAMIC SUBSTRATE, JOINED BODY, SEMICONDUCTOR DEVICE, METHOD FOR MANUFACTURING CERAMIC SUBSTRATE, AND METHOD FOR MANUFACTURING CERAMIC CIRCUIT BOARD**

(30) Priority: 30.03.2022 JP 2022055240
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: IWAI, Kentaro, Yokohama-shi, Kanagawa 235-0032 (JP); SASAKI, Akito, Yokohama-shi, Kanagawa 235-0032 (JP)
(74) Representative: Henkel & Partner mbB
(86) International application number: PCT/JP2023/012928
(87) International publication number: WO 2023/190738

(57) **Abstract**

Provided is a ceramic substrate in which the yield when forming cut-out portions is improved. A ceramic substrate according to an embodiment of the present invention has obverse and reverse surfaces. The ceramic substrate is provided with one or more cut-out portions. There are openings in the cut-out portions. Of the angles at ends in the openings, at least one of angles (θ₃) at locations in which the ceramic substrate is present when seen from the obverse surface is greater than 90 degrees.

## Description

### [Technical Field]

Embodiments described below generally relate to a ceramic substrate, a joined body, a semiconductor device, a method for manufacturing a ceramic substrate, and a method for manufacturing a ceramic circuit board.

### [Background Art]

An insulating circuit board in which an insulating substrate and a circuit part are bonded is used as a substrate to which a semiconductor element is mounted. Fastening by screwing is used as a fixing method of the insulating circuit board. Screw-fastening methods include a method of providing a screw retaining part in the substrate and a method using a fixing jig. In recent years, methods of providing a screw retaining part in the substrate have been tried in an effort to conserve space and stabilize the screw-fastening position. The screw retaining part that is provided in the substrate is called a notched portion.

When opening end portions of the notched portion of the ceramic substrate are right angles as in Patent Literature 1 or 2, the screw may impact the opening end portion when fastening. It was found that chipping and/or cracks easily occur at the opening end portion periphery at such a time.

### [Prior Art Documents]

### [Patent Literature]

Patent Literature 1: JP-A 2005-56933 (Kokai)
Patent Literature 2: International Publication No. 2011/004798

### [Summary of Invention]

### [Problem to be Solved by Invention]

In a conventional ceramic substrate, the end portions of the opening portion are right angles. Therefore, problems such as cracks and/or chipping of the substrate easily occur when fastening by screwing. The invention is directed to address such problems, and is directed to provide a ceramic substrate including a front surface (a first surface) and a back surface (a second surface), in which the substrate includes a notched portion in at least one location of the ceramic substrate, and at least one angle (*θ₃*) where the substrate is present when viewed from the front surface among angles of end portions of the opening portion is greater than 90 degrees.

### [Means for Solving Problem]

A ceramic substrate according to an embodiment includes a front surface (a first surface) and a back surface (a second surface), in which the ceramic substrate includes at least one notched portion, and at least one angle (*θ₃*) where the substrate is present when viewed from the front surface among angles of end portions of the opening portion is greater than 90 degrees.

### [Brief Description of Drawings]

[FIG. 1]

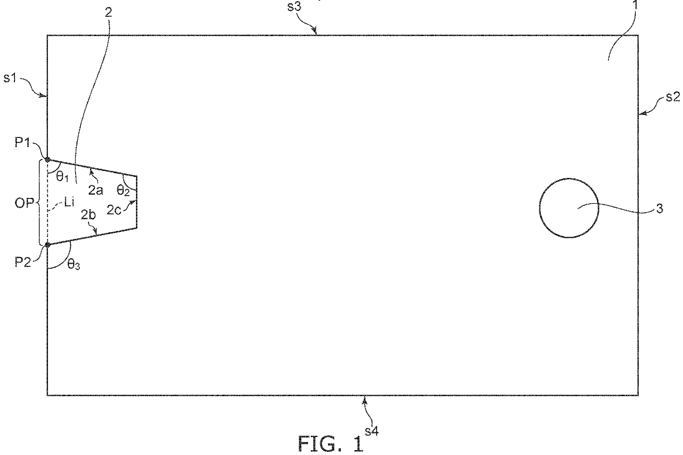

   FIG. 1 is a schematic view showing an example of a ceramic substrate according to an embodiment having a structure in which a notched shape and a through-hole are provided.
[FIG. 2]

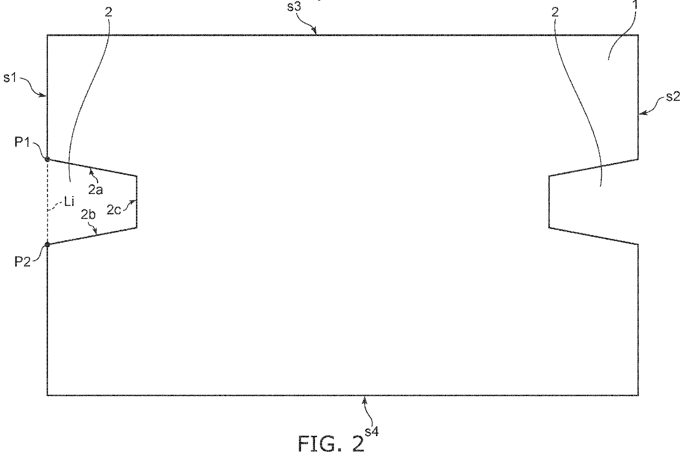

   FIG. 2 is a schematic view showing an example when the notched shape is provided in the ceramic substrate according to the embodiment.
[FIG. 3]

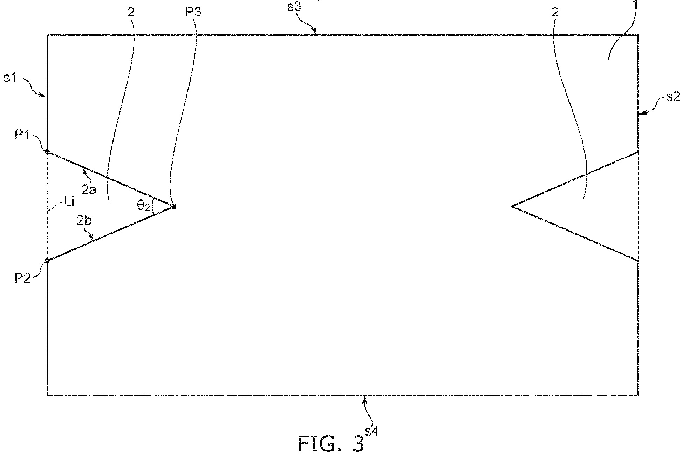

   FIG. 3 is a schematic view showing an example when a notched shape is provided in the ceramic substrate according to the embodiment.
[FIG. 4]

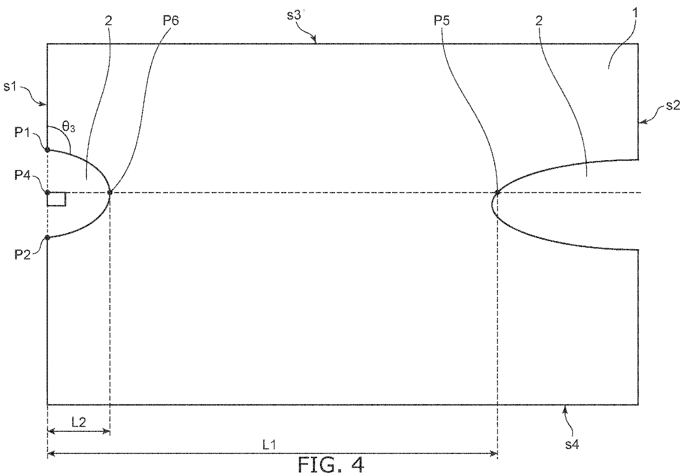

   FIG. 4 is a schematic view showing an example when the notched shape is provided in the ceramic substrate according to the embodiment.
[FIG. 5]

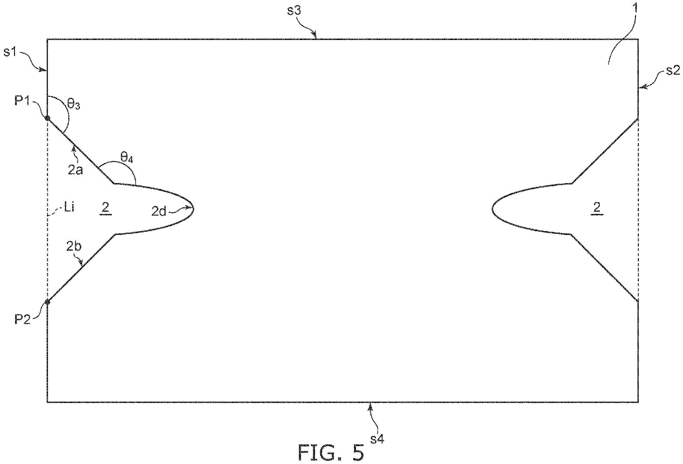

   FIG. 5 is a schematic view showing an example when the notched shape is provided in the ceramic substrate according to the embodiment.
[FIG. 6]

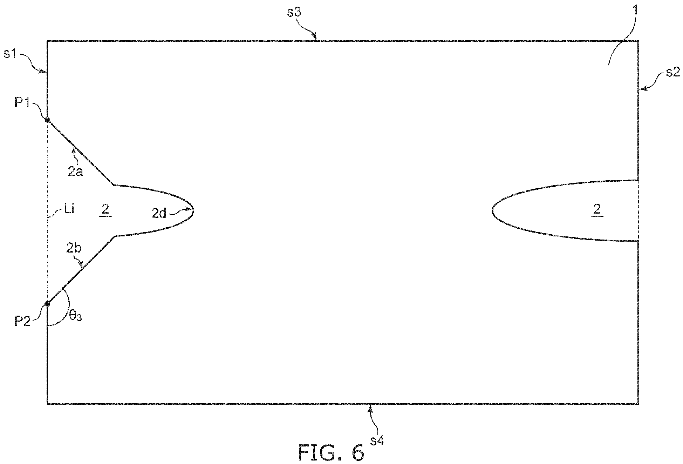

   FIG. 6 is a schematic view showing an example when the notched shape is provided in the ceramic substrate according to the embodiment.
[FIG. 7]

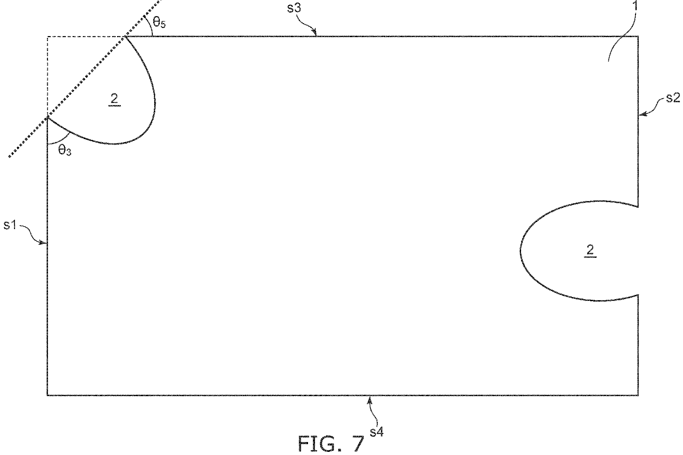

   FIG. 7 is a schematic view showing an example when a notched shape is provided in a ceramic substrate according to an embodiment (a comparative example).
[FIG. 8]

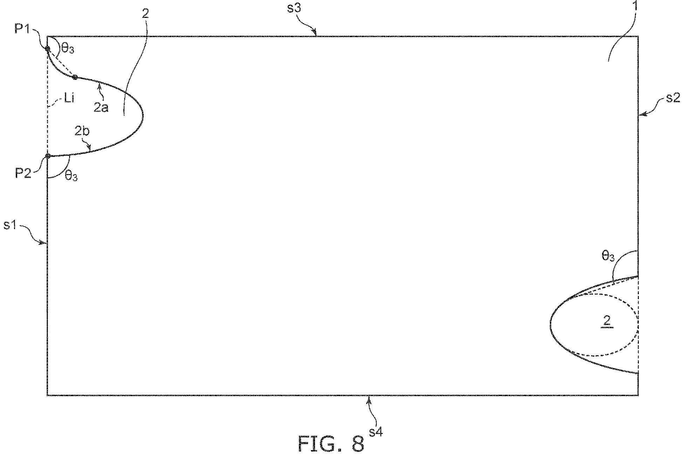

   FIG. 8 is a schematic view showing an example when the notched shape is provided in the ceramic substrate according to the embodiment.
[FIG. 9]

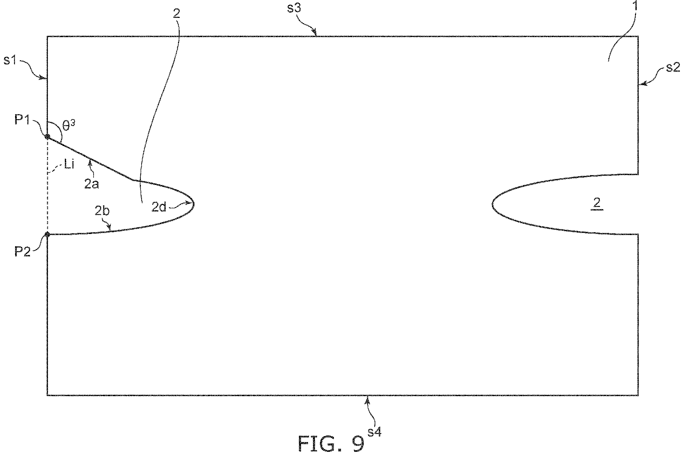

   FIG. 9 is a schematic view showing an example when the notched shape is provided in the ceramic substrate according to the embodiment.
[FIG. 10]

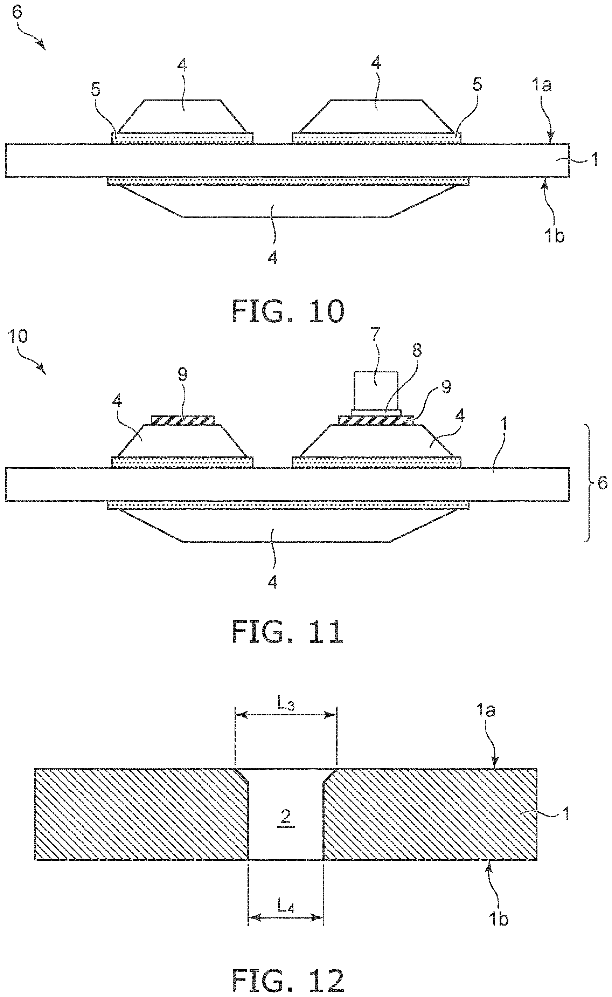

   FIG. 10 is a schematic view showing an example of a semiconductor device according to an embodiment.
[FIG. 11]
   FIG. 11 is a schematic view showing another example of the semiconductor device according to the embodiment.
[FIG. 12]
   FIG. 12 is a schematic view showing an example of a side surface shape of a notched portion shape of the ceramic substrate according to the embodiment.
[FIG. 13]

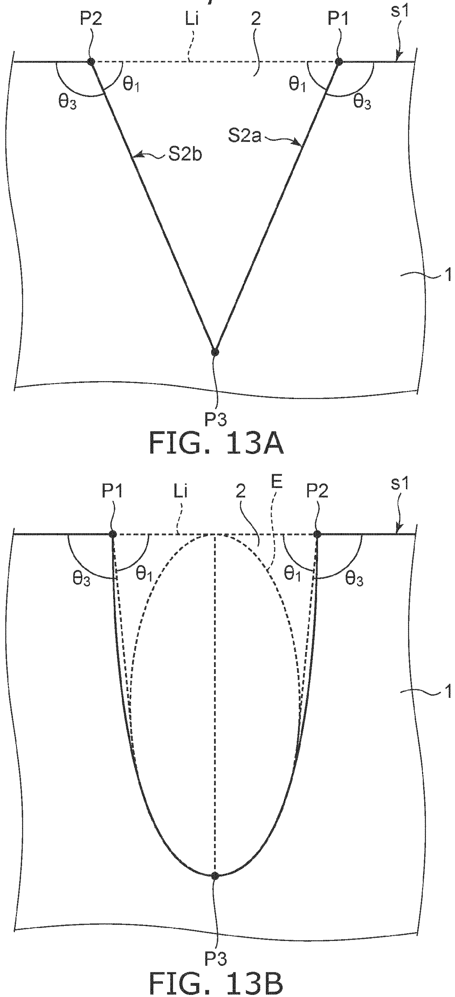

   FIG. 13 is a schematic view illustrating a notched portion vicinity of the ceramic substrate according to the embodiment.
[FIG. 14]

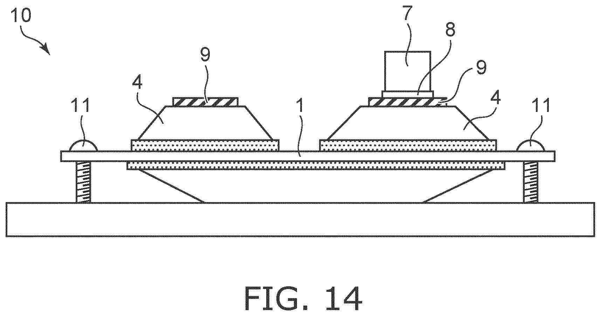

   FIG. 14 is a schematic side view illustrating a state in which the semiconductor device according to the embodiment is fastened by screwing.
[FIG. 15]

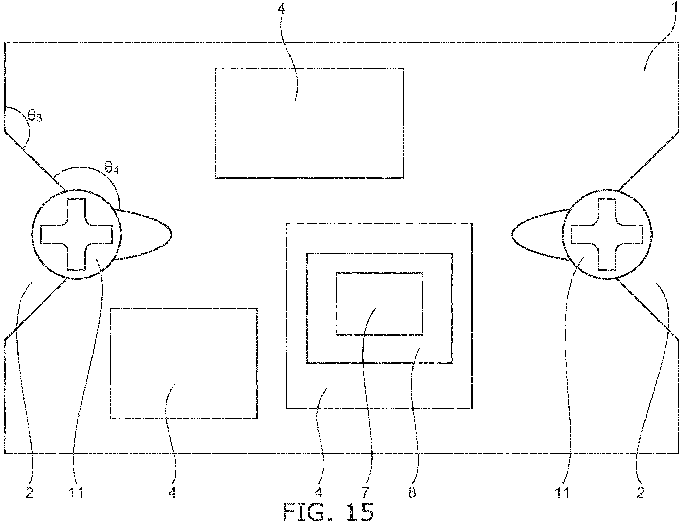

   FIG. 15 is a schematic plan view illustrating the state in which the semiconductor device according to the embodiment is fastened by screwing.
[FIG. 16]

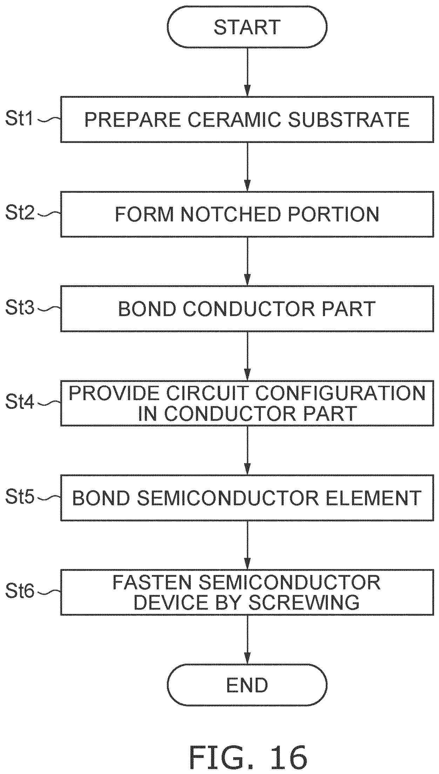

   FIG. 16 is a flowchart illustrating a manufacturing method according to an embodiment.

### [Embodiments of Invention]

An embodiment of the invention is a ceramic substrate including a front surface (a first surface) and a back surface (a second surface); the ceramic substrate includes a notched portion in at least one location; and at least one angle (*θ₃*) where the substrate is present when viewed from the front surface among angles of end portions of the opening portion is greater than 90 degrees. The angle θ₃ is shown in FIG. 1.

In the ceramic substrate according to the embodiment, for example, a notched portion is provided in one location; and a through-hole is provided in one or more locations. Or, multiple notched portions may be provided in two or more locations of the ceramic substrate. When multiple notched portions are provided, the shapes of all of the notched portions may be the same, or the shapes of all of the notched portions may be different from each other. Also, the location in which the notched portion is provided may be a corner of the ceramic substrate. When the ceramic substrate is rectangular (rectangular), the location in which the notched portion is provided may be at a short side or a long side. On the other hand, it is more favorable for the number of notched portions to be not more than 15 per substrate. When the number of notched portions is greater than 15, there is a possibility that the strength of the ceramic substrate may be insufficient. Also, the shape of the ceramic substrate may be substantially circular, substantially elliptical, or substantially semicircular.

The notched portion includes an opening portion that is open toward the edge of the ceramic substrate. Corners of the ceramic substrate are present at the end portions of the opening portion (the opening end portions). A rounded portion or chamfer portion may be formed in the opening end portion. "A rounded portion or chamfer portion may be formed in the opening end portion" includes the formation of a micro chamfer or rounded portion in only the opening end portion vicinity. According to the embodiment according to the invention, the notched portion shape may have asymmetric locations with respect to a perpendicular line drawn from a midpoint between the opening end portions. Also, the notched portion thus formed may be combined with a through-hole, a notched portion having a shape in which the opening portion is narrower than other locations, a notched portion in which the opening portions are right angles, etc. For example, for a curved opening portion, the inflexion point most adjacent to the opening portion is used as the reference when determining whether or not *θ₃* is greater than 90 degrees.

FIG. 1 is a schematic view showing an example of a structure in which a notched shape and a through-hole are provided in a ceramic substrate according to the embodiment. FIG. 2 is a schematic view showing an example of a structure in which notched shapes are provided in the ceramic substrate according to the embodiment.

In FIGS. 1 and 2, the reference numeral 1 is a ceramic substrate, and the reference numeral 2 is a notched portion. The reference numeral 3 is a through-hole. The reference numeral P1 is a first opening end portion. The reference numeral P2 is a second opening end portion. The reference numeral Li is a virtual straight line connecting the first opening end portion P1 and the second opening end portion P2. The reference numeral θ₁ is the angle of the notched side made of the straight line Li and the notched portion 2 (surrounded with a substrate portion). The reference numeral OP is the opening portion of the notched portion 2. FIG. 2 shows a structure for which the notched portion 2 is provided to be substantially trapezoidal at the side not at the opening portion OP. Also, FIG. 2 illustrates a combination of the notched portion 2 and another notched portion 2.

FIGS. 3 to 9 are schematic views showing examples of structures in which the notched portion 2 is provided in the ceramic substrate 1 according to the embodiment. FIG. 3 illustrates a structure in which the notched portion 2 having a substantially-V shape is provided. In FIG. 3, the reference numeral P3 is the end portion of the notched portion 2 at the non-opening side. The reference numeral θ₂ is the angle of the end portion P3 at the non-opening portion side.

FIG. 4 illustrates a structure in which a substantially semicircular notched portion 2 is formed. In FIG. 4, the reference numeral P4 is the midpoint between the opening end portions. The reference numeral P5 is the most distant point among the intersections between the ceramic substrate 1 and a perpendicular line drawn from the midpoint between opening end portions. The reference numeral P6 is the intersection between the perpendicular line drawn from the midpoint between opening end portions and the notched portion 2 having the opening portion. The reference numeral L₁ is the distance between the midpoint P4 and the intersection P5. The reference numeral L₂ is the distance between the midpoint P4 and the intersection P6.

FIG. 5 is a schematic view illustrating the notched portion 2 having a shape in which a substantially-U shape and a substantially-V shape are combined. In FIG. 5, the reference numeral θ₃ is the angle where the ceramic substrate 1 is present at the end portion of the notched portion 2. The reference numeral θ₄ is the angle between the rounded portion and the boundary portion of the opening portion, or the angle between the chamfer portion and the boundary portion of the opening portion. The boundary portion of the opening portion refers to the boundary portion between the opening portion and the ceramic substrate 1.

FIG. 6 is a schematic view illustrating a structure in which the notched portions 2 at two locations do not have the same shape. FIG. 7 is a schematic view illustrating a structure as a comparative example in which a notched portion 2 that has a wide opening is formed in the corner of the ceramic substrate 1. Also, FIG. 7 shows an example in which the notched portion 2 at another location has a shape similar to the through-hole 3. In FIG. 7, the shape of the notched location of the notched portion has a wide opening, and so the impact risk when fastening by screwing can be reduced, but the opening end portions of the substrate have undesirably sharp shapes. Therefore, the risk of the occurrence of cracks and/or chipping at impact may be undesirably greater than when *θ₃* is greater than 90 degrees. In the example shown in FIG. 7, a sharp shape easily occurs in the ceramic substrate 1 because an angle such as that exemplified by *θ₅* is present. *θ₅* is the angle from an extension line of a straight line connecting the opening end portions to each other to the location where the substrate is present. FIG. 8 is a schematic view illustrating a structure in which an opening end portion of the notched portion 2 includes a location beveled into a rounded shape. FIG. 9 is a schematic view illustrating a structure in which an opening end portion of the notched portion 2 includes a location beveled into a chamfer shape.

FIG. 10 is a schematic view illustrating a joined body in which a conductor part is disposed on the ceramic substrate 1, and the ceramic substrate 1 and the conductor part are bonded. In FIG. 10, the reference numeral 4 is a conductor part, the reference numeral 5 is an active metal bonding layer, and the reference numeral 6 is a joined body. FIG. 11 is a schematic view illustrating a semiconductor device in which a semiconductor element is mounted to the joined body shown in FIG. 10. In FIG. 11, the reference numeral 7 is a semiconductor element, the reference numeral 8 is a bonding layer (a semiconductor element and a conductor part), the reference numeral 9 is a plating film, and the reference numeral 10 is a semiconductor device. FIG. 12 is a schematic view showing an example of a side surface shape of the notched portion 2 of the ceramic substrate 1.

Among the angles of the opening end portions, the angle of the ceramic substrate 1 between the notched portion 2 and the straight line connecting the opening end portions to each other in the same notched portion 2 is taken as *θ₃*. In such a case, it is favorable for the ceramic substrate 1 to include a location where the angle θ₃ is greater than 90 degrees. It is more favorable for the angles θ₃ of the two end portions of one notched portion 2 at the opening side each to be greater than 90 degrees.

The range of the angle θ₃ is more favorably not less than 100 degrees and not more than 170 degrees, and more favorably not less than 100 degrees and not more than 160 degrees. More favorably, the angle θ₃ is not less than 120 degrees and not more than 150 degrees. When the angle θ₃ is less than 100 degrees and is too small, there is a possibility that the effect of the angle of the opening portion being greater than 90 degrees may be insufficient. On the other hand, when the angle is greater than 170 degrees, the area occupied by the end portion of the notched portion 2 shape may become too large as described above, and there is a possibility that a sufficient mounting surface of the semiconductor element in the ceramic substrate 1 cannot be ensured. Also, in each opening portion of the notched portion 2, two angles are present at portions where the ceramic substrate 1 is present. It is favorable for the difference between these two angles to be less than 20 degrees. Furthermore, it is more favorable for the difference to be less than 10 degrees.

When the ceramic substrate 1 includes multiple notched portions 2, it is sufficient for the angle θ₃ to be greater than 90 degrees in at least one location. More favorably, the angles θ₃ at the two ends of the opening portion present in at least one notched portion 2 are not less than 90 degrees. It is more favorable for all of the angles θ₃ of the multiple notched portions 2 to be greater than 90 degrees.

A rounded portion or chamfer portion may be formed at the substrate center side of the opening end portion. As described above, when a rounded portion or chamfer portion is formed at the substrate center side of the opening end portion, the angle at the notched portion 2 side between the straight line including the opening end portions and the boundary portion (the inflexion point) between the rounded portion or chamfer portion and the other portion is taken as *θ₁*. The size of the rounded portion or chamfer portion is not particularly limited; and the rounded portion or chamfer portion may be provided in only an opening end portion vicinity.

FIGS. 13A and 13B are schematic views illustrating notched portion vicinities of the ceramic substrate according to the embodiment.

When an inflexion point is not present, the angles θ₁ and θ₃ are determined using a method such as the following. As shown in FIG. 13A, when the shape from the opening end portion P1 or P2 to the end portion P3 at the non-opening side is a substantially linear shape, the angles θ₁ and θ₃ are determined using the straight line Li and the straight line along the shape.

When the shape from the opening end portion P1 or P2 to the end portion P3 is curved as shown in FIG. 13B, first, the location of the notched portion 2 most distant to the straight line Li is determined. In the illustrated example, the end portion P3 corresponds to the most distant location. An ellipse E that has a straight line connecting the most distant location and the straight line Li as the major axis approximates the shape of the notched portion 2. The notched portion 2 is approximated by the ellipse E so that the outer edge of the ellipse E best fits the side surface of the notched portion 2. The boundary portion between the portion shared by the ellipse E and the notched portion 2 and the portion not shared by the ellipse E and the notched portion 2 is determined. The angles θ₁ and θ₃ are determined by using, as a reference, a straight line passing through the boundary portion and the opening end portion P1 or a straight line passing through the boundary portion and the opening end portion P2.

It is favorable for the end portion of the notched portion 2 at the non-opening portion side to have a substantially-U shape, substantially-trapezoidal shape, or substantially-V shape. When the end portion at the non-opening portion side has a substantially-V shape, it is favorable for the angle at the notched portion 2 side to be not less than 70 degrees. When the angle is less than 70 degrees, there is a possibility that cracks may occur from this end portion. As described above, as long as the angle at the notched portion 2 side of the end portion at the non-opening portion side is not less than 70 degrees, the end portion may have a substantially-V shape. The angle of the end portion at the non-opening portion side is taken as the angle θ₂. The angle θ₂ is the angle between the side surfaces of the notched portion 2. FIG. 3 shows the angle θ₂. For example, as shown in FIGS. 4 and 8, a substantially-U shape refers to a shape in which the end portion at the non-opening portion side includes a rounded portion. For example, as shown in FIGS. 1 and 2, a substantially-trapezoidal shape refers to a shape in which the end portion at the non-opening portion side includes a chamfer portion. The notched portion 2 may be a polygonal shape that is substantially pentagonal, substantially hexagonal, etc.

By providing a bevel portion at a location at the non-opening portion side, the effect of suppressing the occurrence of cracks at this end portion can be further increased. By including a rounded portion or chamfer portion at this bevel portion, the effect of suppressing the occurrence of cracks at this end portion can be even further increased. It is therefore more favorable to provide a rounded portion or chamfer portion at a location at the non-opening portion side.

It is favorable for the shape of the end portion at the non-opening portion side to have a substantially-V shape (the angle of the substantial V being not less than 70 degrees), a substantially-trapezoidal shape, or a substantially-U shape. The size of the substantially-V shape (the angle of the substantial V being not less than 70 degrees), the substantially-trapezoidal shape, or the substantially-U shape is arbitrary. For example, such a shape may be an extremely small shape provided at a very small portion of the notched portion 2 shape. Or, such a shape may be formed over the entire notched portion 2. When the rounded portion or the chamfer portion has a substantially-U shape, the effect of suppressing the occurrence of cracks can be further increased. It is therefore more favorable for the rounded portion or the chamfer portion to have a substantially-U shape.

Here, the rounded portion refers to a shape in which a substantially-U shape is formed by cutting away the corner at the tip of the notched portion 2 to be rounded. The tip refers to the end portion of the notched portion 2 at the non-opening portion side. The chamfer portion refers to a shape in which a substantially-trapezoidal shape is formed by linearly cutting away the corner at the tip of the notched portion 2. Thus, when the chamfer portion is provided, it is more favorable for the angle at the notched portion side that is made of the upper base of the trapezoid to be not less than 30 degrees. In such a case, it is more favorable for the ratio (upper base/lower base) of the upper base and the lower base of the substantial trapezoid to be not less than 0.1. The upper base of the substantial trapezoid is the length of the side of the tip of the notched portion 2. The lower base of the substantial trapezoid is the length of the opening portion of the notched portion 2. Therefore, the lower base of the substantial trapezoid is the length of the straight line connecting the opening end portions to each other. As a result, compared to when fastening the ceramic substrate 1 in which a substantially-V shape is formed by screwing, it is possible to further reduce the likelihood of the occurrence of cracking or chipping of the ceramic substrate 1.

Similarly to the angle θ₃, the shape of the location at the non-opening portion side can be determined by viewing toward the front surface portion. Furthermore, the side surface shape of the location at the non-opening portion side is determined using the shape when viewing toward the surface formed by the side surface portion of the notched portion 2. This shape also may include a rounded portion or a chamfer portion.

Even when the angle of the notched portion made of the notched portion 2 and the opening end portions (e.g., the angle labeled *θ₁* in FIG. 1) is less than 90 degrees, there are cases where the ceramic substrate 1 becomes partially fine at the opening end portion when the opening portion is provided in a corner of a quadrilateral ceramic substrate 1 that is rectangular, square, etc. In such a case, it is difficult to maintain sufficient strength at the corner. Accordingly, it is favorable to provide locations at which the interior angle of the ceramic substrate 1 is not less than 100 degrees at the angles of the two end portions of the opening portion.

It is favorable to control the side surface shape as well. In the side surface shape, it is favorable for at least one location among the end portion of the ceramic substrate 1 at the front side and the end portion of the ceramic substrate 1 at the backside to include a rounded portion or a chamfer portion. When the ceramic substrate 1 is viewed from the side, it is more favorable for the two end portions at the front side to include a micro rounded portion or chamfer portion as shown in FIG. 12. The notched portion 2 may be wide, and the notched portion 2 may be open at both the end portion at the front side and the end portion at the backside.

It is favorable for the arithmetic average roughness Ra of the side surface to be not more than 1.2 µm. Furthermore, it is favorable for the maximum height Rz of the side surface to be not more than 2.0 µm. *Ra* and *Rz* are described in JIS B 0601:2013. JIS B 0601:2013 corresponds to ISO 4287:1997/Amendment 1:2009 (IDT). The surface roughness due to the patterning can be controlled by adjusting the patterning method. It is therefore favorable for the arithmetic average roughness Ra of the side surface to be not more than 1.2 µm, and for the maximum height Rz of the side surface to be not more than 2.0 µm. Examples of control methods of the surface roughness due to the patterning include, for example, a method of performing blasting or honing after the patterning, a method of controlling the irradiation diameter or energy density of laser patterning, etc. By controlling the surface roughness of the side surface portion, the screwing efficiency when fastening by screwing can be increased.

As shown in FIG. 4, the midpoint between the end portions of the opening portion OP of the notched portion 2 is taken as *P4.* When a perpendicular line is drawn from the midpoint P4, the point on the end portion of the ceramic substrate 1 most distant to the midpoint P4 among the end portions of the ceramic substrate 1 on the perpendicular line is taken as *P5.* The length of the ceramic substrate 1 between the midpoint P4 and the intersection P5 is taken as *L₁.* The intersection between the perpendicular line and the notched portion 2 having the opening portion is taken as *P6.* In such a case, it is favorable for *L₂*/*L₁* to be not less than 0.1 and not more than 0.4 for the length (*L₂*) of the notched portion 2 defined by the distance between the midpoint P4 and the intersection P6. For a combination of the notched portion 2 and the through-hole 3, when the through-hole 3 is on the perpendicular line drawn from the midpoint P4, the end portion of the ceramic substrate 1 most distant to the midpoint P4 ignoring the through-hole 3 is taken as the intersection P5.

When the perpendicular line drawn from the midpoint between one end portion (the first opening end portion P1) and another end portion (the second opening end portion P2) of the opening portion does not cross another notched portion 2, the length to the intersection between the perpendicular line and the ceramic substrate 1 is taken as *L₁.* When the perpendicular line drawn from the midpoint between opening end portions crosses another notched portion 2, the distance between the straight line connecting the opening end portions of the other notched portion 2 to each other and the midpoint between opening end portions is taken as *L₁.* Also, the longest distance along the perpendicular line drawn from the straight line connecting the opening end portions to each other to intersections with the edge of the notched portion 2 is taken as *L₂.* In such a case, it is favorable for *L₂*/*L₁* to be not less than 0.1 and not more than 0.4. More favorably, *L₂*/*L₁* is not less than 0.1 and not more than 0.35. When *L₂*/*L₁* is greater than 0.4, there is a possibility that the ceramic substrate 1 may crack more easily. On the other hand, when *L₂*/*L₁* is less than 0.1, there is a possibility that the effect of providing the notched portion 2 may be insufficient. That is, when the notched portion 2 is not at the corner and the notched portion 2 is present at only one location, the length L₁ corresponds to the length of the ceramic substrate 1.

As shown in FIG. 12, the maximum width when viewed from the side surface of the notched portion 2 is taken as *L₃*; and the smallest opening width of the notched portion 2 including the maximum width L₃ is taken as *L₄.* In such a case, it is favorable for 0.5 ≤ *L₄*/*L₃ <* 1. The direction of the width L₃ is parallel to the direction of the width L₄ and parallel to the direction connecting the first opening end portion P1 and the second opening end portion P2. When *L₄*/*L₃* is less than 0.5, there is a possibility that the opening end portion may chip easily. On the other hand, when *L₄*/*L₃* is not less than 1, there is a possibility that the effect of setting the angle of the opening portion to be greater than 90 degrees may be insufficient; and the positional accuracy of the screw retaining part may be degraded. It is more favorable for *L₄*/*L₃* to be 0.7 < *L₄*/*L₃ <* 1.

FIG. 14 is a schematic side view illustrating a state in which the semiconductor device according to the embodiment is fastened by screwing. FIG. 15 is a schematic plan view illustrating the state in which the semiconductor device according to the embodiment is fastened by screwing. In FIGS. 14 and 15, the reference numeral 11 is a screw. As shown in FIGS. 14 and 15, a screw is passed through the notched portion 2 when fixing the semiconductor device 10. The semiconductor device 10 is fixed with respect to the support plate by the ceramic substrate 1 being pressed toward the support plate by the screw 11.

According to the embodiment, the screw 11 does not easily impact the ceramic substrate 1 when disposing the screw 11 in the notched portion 2 of the ceramic substrate 1. Also, by setting the angle θ₃ to be greater than 90 degrees, the application of a large local force to the ceramic substrate 1 can be avoided even if the screw 11 impacts the ceramic substrate 1. The occurrence of chipping or cracks of the ceramic substrate 1 can be suppressed thereby.

It is favorable for the ceramic substrate 1 to include one or two selected from silicon nitride, aluminum nitride, sialon, alumina, and zirconia as a major component. The major component refers to a component included at not less than 50 mass%. Also, it is more favorable for the ceramic substrate to be one of a silicon nitride substrate, an aluminum nitride substrate, or an Alusil substrate. Alusil is a material that includes a total of not less than 50 mass% of the two components of alumina and zirconia.

It is favorable for the thickness of the ceramic substrate 1 to be not less than 0.1 mm and not more than 3 mm, and more favorably not less than 0.1 mm and not more than 1 mm. When the thickness of the ceramic substrate 1 is less than 0.1 mm, there is a possibility that the strength of the ceramic substrate 1 may be reduced. When the thickness of the ceramic substrate 1 is greater than 3 mm, there is a possibility that the ceramic substrate 1 itself may become a thermal resistor, and the heat dissipation of the ceramic circuit board may degrade.

It is favorable for the three-point bending strength of the silicon nitride substrate to be not less than 600 MPa. It is favorable for the thermal conductivity of the silicon nitride substrate to be not less than 80 W/m·K. By increasing the strength of the silicon nitride substrate, the substrate thickness can be reduced. It is therefore favorable for the three-point bending strength of the silicon nitride substrate to be not less than 600 MPa, or even not less than 700 MPa. The thickness of the silicon nitride substrate can be reduced to be not more than 0.40 mm, or even not more than 0.30 mm. Also, the three-point bending strength of the aluminum nitride substrate is about 300 to 450 MPa. On the other hand, the thermal conductivity of the aluminum nitride substrate is not less than 160 W/m·K. It is favorable for the substrate thickness to be not less than 0.60 mm because the strength of the aluminum nitride substrate is low.

Although the three-point bending strength of the aluminum oxide substrate is about 300 to 450 MPa, the aluminum oxide substrate is an inexpensive ceramic substrate. Although the three-point bending strength of the Alusil substrate is as high as about 550 MPa, the thermal conductivity of the Alusil substrate is about 30 to 50 W/m·K. The Alusil substrate is a substrate made of a sintered body in which aluminum oxide and zirconium oxide are mixed. It is favorable for the ceramic substrate to be a nitrogen-including ceramic substrate. Also, it is more favorable for the nitrogen-including ceramic substrate to be a nitride ceramic, and more favorably one of a silicon nitride substrate or an aluminum nitride substrate.

It is favorable for the thickness of the ceramic substrate to be not less than 0.1 mm and not more than 1 mm. When the substrate thickness is less than 0.1 mm, there is a possibility that the strength may be insufficient. Also, when the substrate thickness is greater than 1 mm, there is a possibility that the ceramic substrate 1 itself may become a thermal resistor, and the heat dissipation of the circuit board may degrade.

The notched portion 2 of the ceramic substrate 1 according to the embodiment of the invention can be favorably used for fastening by screwing.

It is favorable for the silicon nitride substrate to have a three-point bending strength of not less than 600 MPa. It is favorable for the thermal conductivity to be not less than 80 W/m K. By increasing the strength of the silicon nitride substrate, the substrate thickness can be reduced. It is therefore favorable for the three-point bending strength of the silicon nitride substrate to be not less than 600 MPa, and more favorably not less than 700 MPa. The substrate thickness of the silicon nitride substrate can be reduced to be not more than 0.40 mm, or even not more than 0.30 mm.

The three-point bending strength of the aluminum nitride substrate is about 300 to 450 MPa. On the other hand, the thermal conductivity of the aluminum nitride substrate is not less than 160 W/m K. It is favorable for the substrate thickness to be not less than 0.60 mm because the strength of the aluminum nitride substrate is low. Although the three-point bending strength of the aluminum oxide substrate is about 300 to 450 MPa, the aluminum oxide substrate is inexpensive. The three-point bending strength of the Alusil substrate is as high as about 550 MPa, but the thermal conductivity of the Alusil substrate is about 30 to 50 W/m K. An Alusil substrate refers to a substrate made of a sintered body in which aluminum oxide and zirconium oxide are mixed.

The conductor part 4 may be bonded to the ceramic substrate 1 that includes the notched portion 2 described above. The notched portion 2 that has the shape described above may be formed in the joined body 6 in which the ceramic substrate 1 and the conductor part 4 are bonded. The conductor part 4 may be located at only one surface of the ceramic substrate 1. The conductor part 4 may be located respectively at two surfaces of the ceramic substrate 1. Herein, the conductor part 4 that is located at the front surface of the ceramic substrate 1 is called a front conductor part. The conductor part 4 that is located at the back surface of the ceramic substrate 1 is called a back conductor part. The composition of the front conductor part and the composition of the back conductor part may be different from each other. When the composition of the front conductor part and the composition of the back conductor part are the same, it is possible to provide a joined body that is easy to use. It is therefore more favorable for the composition of the front conductor part and the composition of the back conductor part to be the same.

It is favorable for the conductor part 4 to be a copper member or an aluminum member. The copper member is made of copper or a copper alloy. The copper member is a copper plate, a copper alloy plate, a member in which a circuit configuration is provided in a copper plate, or a member in which a circuit configuration is provided in a copper alloy plate. The aluminum member is made of aluminum or an aluminum alloy. The aluminum member is an aluminum plate, an aluminum alloy plate, a member in which a circuit configuration is provided in an aluminum plate, or a member in which a circuit configuration is provided in an aluminum alloy plate. A member made by providing a circuit configuration in a copper plate is called a copper circuit. A member made by providing a circuit configuration in an aluminum plate is called an aluminum circuit.

Examples of advantages of the conductor part 4 including aluminum include a lower cost than copper. When the conductor part 4 includes aluminum, an Al brazing material such as an Al-Mg alloy brazing material, etc., can be used. On the other hand, the copper member has a higher thermal conductivity than an aluminum member. It is therefore favorable for the conductor part 4 to include a copper member. Other than the copper member or the aluminum member, the conductor part 4 may be a metalized layer or an electrically-conductive thin film. The metalized layer is formed by firing a metal paste. The thickness of the conductor part 4 may be not less than 0.3 mm, or even not less than 0.6 mm. The heat dissipation of the joined body 6 can be improved by making the conductor part 4 thick. The thickness of the front conductor part may be equal to the thickness of the back conductor part or different from the thickness of the back conductor part. A copper member is especially favorable as the conductor part 4. It is favorable for the copper member to be made of oxygen-free copper. Oxygen-free copper has a copper purity of not less than 99.96 mass% as indicated in JIS-H-3100.

The ceramic substrate 1 and the copper member may be directly bonded. A stamped copper plate may be bonded to the ceramic substrate 1. A copper plate may be bonded to the ceramic substrate 1, and then the copper plate may be etched. When a brazing material is used to bond, it is favorable to bond the ceramic substrate 1 and the copper member via a bonding layer that includes titanium. In active metal bonding, an active metal brazing material that includes Ti is used. For example, the active metal brazing material includes silver or copper as a major component (not less than 50 mass%), and includes Ti. Also, it is favorable for the ceramic substrate and the copper member to be bonded via a bonding layer that includes carbon. By the active metal brazing material including carbon, a bonding layer that includes carbon can be formed. By the active metal brazing material including carbon, the fluidity of the brazing material can be improved. As a result, the bonding strength can be increased.

The active metal brazing material may be a brazing material in which Ag and Ti are combined, or a brazing material in which copper and Ti are combined. For example, it is favorable for the active metal brazing material to include not less than 0 mass% and not more than 98 amount% Ag (silver), not less than 1 mass% and not more than 85 mass% Cu (copper), and not less than 1 mass% and not more than 15 mass% Ti (titanium) or TiH₂ (titanium hydride). Also, the active metal brazing material may include Nb or Zr instead of Ti; and Nb and Zr may be added in addition to Ti. However, it is favorable for the active metal brazing material to include not less than 1 mass% and not more than 15 mass% Ti (titanium) or TiH₂ (titanium hydride). When both Ti and TiH₂ are used, the total of Ti and TiH₂ is set to be within the range of not less than 1 mass% and not more than 15 mass%. When both Ag and Cu are used, it is favorable for the Ag content to be not less than 20 mass% and not more than 70 mass%, and for the Cu content to be not less than 15 mass% and not more than 65 mass%. The brazing material may include not less than 1 mass% and not more than 50 mass% of at least one selected from Sn (tin), In (indium), and Mn (manganese) as necessary. It is favorable for the content of Ti or TiH₂ to be not less than 1 mass% and not more than 15 mass%. Also, the brazing material may include not less than 0.1 mass% and not more than 2 mass% of C (carbon) as necessary.

The composition ratio of the active metal brazing material is calculated using the total of the mixed solid raw materials as 100 mass%. It is favorable for the solid raw materials to be powders. For example, when the active metal brazing material includes the three of Ag, Cu, and Ti, then Ag + Cu + Ti = 100 mass% is used. When the active metal brazing material includes the four of Ag, Cu, TiH₂, and In, Ag + Cu + TiH₂ + In = 100 mass% is used. When the active metal brazing material includes the five of Ag, Cu, Ti, Sn, and C, Ag + Cu + Ti + Sn + C = 100 mass% is used. It is favorable to mix a solvent corresponding to the composition for the powder raw materials of the compositions described above. The brazing material can have a paste form by mixing a solvent.

The prepared brazing material paste is coated onto the ceramic substrate 1; and the conductor part 4 is disposed on the brazing material paste. The ceramic substrate 1 and the conductor part 4 are bonded by heating the obtained stacked body. As a result, the joined body 6 is obtained.

The notched portion 2 described above may be provided in the joined body 6 thus obtained. The conductor part 4 may be provided on the ceramic substrate 1 in which the notched portion 2 described above is provided. The conductor part 4 that is provided with a circuit configuration beforehand may be bonded to the ceramic substrate 1. A circuit configuration may be provided in the conductor part 4 after bonding the conductor part 4 to the ceramic substrate 1. Herein, the joined body 6 in which a circuit configuration is provided in the conductor part 4 also is called a ceramic circuit board.

It is favorable for the side surface of the conductor part described above to include an inclined shape. In other words, it is favorable for the side surface of the copper member to be inclined with respect to in-plane direction and thickness direction. The in-plane direction is a direction parallel to the bonding surface between the ceramic substrate 1 and the conductor part. The thickness direction is a direction connecting the ceramic substrate 1 and the conductor part, and is perpendicular to the in-plane direction. It is favorable for the conductor part to be a copper member.

It is favorable for the thickness of the bonding layer 5 to be within the range of not less than 10 µm and not more than 60 µm. It is favorable for the ceramic circuit board to have a shape in which the bonding layer 5 juts from the side surface of the conductor part. The jutting portion of the bonding layer 5 is called a bonding layer jutting part. It is favorable for the ratio (L/T) of a length L to a thickness T of the bonding layer jutting part to be within the range of not less than 0.5 and not more than 3.0. The thickness of the bonding layer jutting part is the thickest thickness of the bonding layer jutting part. The length of the bonding layer jutting part is the longest length of the bonding layer jutting part jutting from the conductor part side surface. The thickness and length of the bonding layer jutting part are measured from any cross section of the ceramic copper circuit board. The TCT characteristics of the ceramic copper circuit board can be improved by providing the inclined shape in the conductor part and by providing the bonding layer jutting part.

Examples of the bonding layer 8 used to bond between the plating film 9 and the semiconductor element 7 or bond between the conductor part 4 and the semiconductor element 7 include a bonding layer including copper or tin, and a bonding layer including solder paste or silver paste. Although FIG. 11 shows a structure including the plating film 9, the plating film 9 may not be included.

It is favorable for the ceramic substrate 1 to be a silicon nitride substrate having a thickness of not more than 0.4 mm, and for the thickness of the conductor part to be not less than 0.6 mm. A thin silicon nitride substrate having a thickness of not more than 0.4 mm has the effect of reducing the thermal resistance of the ceramic substrate. Also, a thick copper plate having a thickness of not less than 0.6 mm improves the heat dissipation. Also, a silicon nitride substrate that has a three-point bending strength of not less than 600 MPa is more effective. Therefore, a silicon substrate that has a thickness of not more than 0.4 mm and a thick copper plate that has a thickness of not less than 0.6 mm may be used in combination.

A manufacturing method according to an embodiment of the invention will now be described.

The method of forming the notched portion 2 is arbitrarily selectable as long as the notched portion 2 described above can be formed. Examples of methods of forming the notched portion 2 include a method of cutting a portion of the ceramic substrate 1 by laser, a method of providing a recess in the ceramic substrate 1 by applying pressure to a green sheet, a method of cutting away a portion of the ceramic substrate 1 with a jigsaw, etc. Among these, the method of forming by laser is more favorable. When the notched portion 2 is formed by laser patterning, a distinct difference in appearance that can be observed by SEM occurs in the ceramic substrate. Therefore, whether or not the notched portion 2 is formed by laser patterning can be determined by observing the notched portion 2 by SEM. The distinct difference in appearance that can be observed by SEM is caused by thermal effects generated in the laser patterning. There are also cases where the portion that is affected by the thermal effect is partially removed when honing or the like is performed. Accordingly, the notched portion 2 can be discriminated to have been formed by laser patterning when a laser patterning mark such as that described above is observed in a portion of the notched portion 2 (at least a portion of the side surface of the notched portion 2).

When forming the notched portion 2 in the ceramic substrate 1, it is favorable for the energy density of the laser to be high. When the energy density of the laser is high, the scan rate can be increased. Also, when the notched portion 2 is formed by laser, the notched portion 2 can be formed with high positional accuracy. Also, by forming the notched portion 2 by laser patterning, it is possible to make a shape in which the front side is open with respect to the substrate central portion when the shape of the notched portion 2 is viewed from the side surface of the ceramic substrate 1. Although not particularly limited, it is favorable for the laser to be used to be at least one selected from a CO₂ laser, a YAG laser (one of a fundamental, a secondorder harmonic, a third-order harmonic, or a fourth-order harmonic), a femtosecond laser, a picosecond laser, a semiconductor laser, a LD laser, an excimer laser, a YVO₄ laser, and a DDL laser. Among these lasers, it is more favorable to use at least one selected from a CO₂ laser and a fiber laser.

According to a method of forming the notched portion 2 by laser patterning, the notched portion 2 may be formed by one laser irradiation, or the notched portion 2 may be formed by multiple laser irradiations. Dust collection or an assist gas may be used as necessary. The laser may be irradiated only from one surface of the ceramic substrate 1, or may be irradiated from two surfaces of the ceramic substrate 1. When lasers are irradiated from two surfaces of the ceramic substrate 1, the positional accuracy with respect to the initial irradiation surface is important. It is therefore more favorable to irradiate the laser from only one surface of the ceramic substrate 1. To form the notched portion 2, a continuous groove may be formed, or the laser may be irradiated in a dot configuration. Among the continuous groove or the dot configuration, the continuous groove is favorable. In the case of a continuous groove, it is easier to cut away the notched portion 2 from the ceramic substrate 1. Also, the output mode of the laser may be pulse or CW (continuous), or both may be combined. The irradiation may be performed multiple times to pierce through.

When a groove is formed by laser, it is favorable to control the maximum depth of the groove with respect to the thickness of the substrate. The thickness of the substrate is taken as *t*, and the maximum depth of the groove is taken as *d*. In such a case, it is favorable for 0.5 < *d*/*t* ≤ 1. Here, when the laser is irradiated from both the front and back surfaces of the ceramic substrate 1, the maximum depth of the groove is represented by the total value. Also, it is more favorable for 0.7 ≤ *d*/*t* ≤ 1.0. More favorably, *d*/*t* is 1.0. In other words, more favorably, the groove that is formed is present at both the front and back surfaces. It is more favorable for the depth d of the groove to be constantly 1.0 with respect to the thickness t of the substrate (the groove extends through). After forming the groove by laser, a separation process is performed to separate the notched portion 2 side from the ceramic substrate 1 to form the notched portion 2. By performing the groove formation so that the groove depth is a certain depth with respect to the substrate thickness, it is unnecessary to obtain the notched portion 2 shape by applying an excessive pressure in the separation process. Therefore, the cost can be reduced. Also, when forming the notched portion 2, the occurrence of burr can be suppressed by the laser patterning causing the groove to extend through. It is favorable to adjust the focusing diameter of the laser. The effects of the laser irradiation can be reduced a certain degree by adjusting the focusing diameter, the energy density, etc. The surface roughness of the side surface portion of the notched portion 2 can be controlled.

The surface roughness of the side surface portion of the ceramic substrate 1 and the surface roughness of the side surface portion of the notched portion 2 may be different. Favorably, when Ra is measured at five locations for each of the notched portion and the side surface portion, the difference between the average value of the substrate side surface portion and the average value of the side surface portion of the notched portion 2 is not more than 3.0 µm. Honing of the ceramic substrate 1 may be performed as necessary. Honing may be performed on the ceramic substrate after sintering, and may be performed before forming the notched portion 2 or after forming the notched portion 2.

The timing of the formation of the notched portion 2 is not particularly limited. When the notched portion 2 is formed in a green sheet, there is a possibility that the subsequent sintering process may reduce the positional accuracy of the notched portion 2. It is therefore favorable for the timing of the formation of the notched portion 2 to be after sintering. The formation of the notched portion 2 may be after bonding the conductor part 4 or before bonding the conductor part 4. The substrate portion has a sharp shape when the notched portion 2 is located at the corner as in FIG. 7. There is a possibility that chipping of the ceramic substrate 1 may occur if a screw impacts an opening end portion when fastening by screwing. Therefore, a structure in which the notched portion 2 is provided in the corner is unfavorable.

When the notched portion 2 is formed in the ceramic substrate 1 using a laser, it is favorable to form the notched portion 2 so that the width of the notched portion 2 at the opening portion OP side is greater than the width of the end portion at the non-opening portion side. More specifically, for the shape of the notched portion 2, the average value of the width over the entire notched portion 2 is taken as *Wa*, wherein "width" is a distance parallel to the line connecting the opening end portions to each other. The width of the opening portion is taken as *Wo*. In such a case, it is favorable for 1.01 ≤ *Wo*/*Wa* ≤ 5.0 to be satisfied. More favorably, 1.2 ≤ *Wo*/*Wa* ≤ 4.0 is satisfied. More favorably, 1.5 ≤ *Wo*/*Wa* ≤ 3.5 is satisfied. When the width of the notched portion 2 is controlled as described above, the opening portion can be prevented from undesirably becoming too wide, and the opening degree of the shape of the opening can be controlled. The effect of controlling the angle of the portion of the opening portion where the substrate is present is easily obtained. Also, by controlling the notched portion 2 shape, torque when fastening by screwing also can be increased.

FIG. 16 is a flowchart illustrating the manufacturing method according to the embodiment.

FIG. 16 shows a favorable example of the manufacturing method according to the embodiment. First, the ceramic substrate 1 is prepared (step St1). The ceramic substrate 1 can be made by the method described above. The notched portion 2 is formed in the ceramic substrate 1 that is prepared (step St2). As a result, the ceramic substrate 1 that includes the notched portion 2 is obtained. Then, the conductor part 4 is bonded to the ceramic substrate 1 (step St3). A circuit configuration is provided by etching the conductor part 4 (step St4). A ceramic circuit board is obtained thereby. Then, the semiconductor element 7 is mounted on the conductor part 4 (step St5). The semiconductor device 10 is obtained thereby. Finally, a screw is passed through the notched portion 2; and the semiconductor device 10 is fixed by screwing (step S6). As described above, the order of the steps and the specific processing performed in the steps are modifiable as appropriate.

From another perspective, the ceramic substrate 1 according to the embodiment of the invention includes a front surface 1a (a first major surface) and a back surface 1b (a second major surface) as shown in FIG. 10. The back surface 1b is positioned at the side opposite to the front surface 1a. As shown in FIG. 1, the ceramic substrate 1 includes side surfaces s1 to s4. The side surfaces s1 to s4 are connected to the front surface 1a and the back surface 1b. The side surfaces s1 to s4 are parallel to the thickness direction connecting the front surface 1a and the back surface 1b. In the illustrated example, the side surface s1 and the side surface s2 are parallel to each other; and the side surface s3 and the side surface s4 are parallel to each other. The notched portion 2 is provided in at least one of the side surfaces s1 to s4, and extends through the ceramic substrate 1 from the front surface 1a to the back surface 1b. In the example shown in FIG. 1, one of the multiple notched portions 2 includes a first surface 2a and a second surface 2b that are connected to the side surface s1 of the ceramic substrate 1. The first surface 2a and the second surface 2b are at least a portion of the side surface of the notched portion 2. The first surface 2a and the second surface 2b are parallel to the thickness direction of the ceramic substrate 1 and are inclined with respect to the side surface s1. The first surface 2a and the second surface 2b face each other in a direction parallel to the side surface s1. The width of the notched portion 2 decreases away from the side surface s1. The first opening end portion P1 is positioned between the side surface s1 and one end of the first surface 2a. The second opening end portion P2 is positioned between the side surface s1 and one end of the second surface 2b. The width of the notched portion 2 corresponds to the distance between the first surface 2a and the second surface 2b in a direction parallel to the side surface s1.

As shown in FIG. 1, the notched portion 2 may further include a third surface 2c. The third surface 2c is connected to the first and second surfaces 2a and 2b, and is positioned between the other end of the first surface 2a and the other end of the second surface 2b. In the example shown in FIGS. 1 and 2, the third surface 2c is parallel to the side surface s1. The angle θ₁ also is an angle between the straight line Li and the first surface 2a. The angle θ₂ also is an angle between the first surface 2a and the third surface 2c or an angle between the second surface 2b and the third surface 2c. The angle θ₃ also is an angle between the first surface 2a and the side surface s1 at the first opening end portion P1 or an angle between the second surface 2b and the side surface s1 at the second opening end portion P2.

In the example shown in FIGS. 3 and 4, the notched portion 2 does not include the third surface 2c. In the structure shown in FIG. 3, the angle θ₂ is the angle between the first surface 2a and the second surface 2b. The first surface 2a and the second surface 2b may be planes as shown in FIGS. 1 to 3, or may be curves as shown in FIG. 4. In the structure shown in FIG. 4, the other end of the first surface 2a and the other end of the second surface 2b are connected. As shown in FIGS. 5 and 6, the notched portion 2 may include a concave surface 2d recessed toward the center of the ceramic substrate 1. The first surface 2a and the second surface 2b are connected to the concave surface 2d. The angle θ₄ also is an angle between the other end of the first surface 2a and one end of the concave surface 2d, or an angle between the other end of the second surface 2b and the other end of the concave surface 2d. Also, the length L₃ shown in FIG. 12 also is the distance between a portion of the first surface 2a and a portion of the second surface 2b. The portion of the first surface 2a and the portion of the second surface 2b face each other in a direction parallel to the side surface s1. The length L₄ also is the distance between another portion of the first surface 2a and another portion of the second surface 2b. The other portion of the first surface 2a and the other portion of the second surface 2b face each other in a direction parallel to the side surface s1. The portion of the first surface 2a is positioned at the front surface 1a side with respect to the other portion of the first surface 2a. The portion of the second surface 2b is positioned at the front surface 1a side with respect to the other portion of the second surface 2b.

### (Examples)

### (Examples 1 to 6 and comparative examples 1 to 2)

Table 1 shows the types and thicknesses of ceramic substrates used. The thermal conductivity of the silicon nitride substrate was 90 W/m·K, and the three-point bending strength was 700 MPa. The thermal conductivity of the aluminum nitride substrate was 170 W/m K, and the three-point bending strength was 400 MPa. The thermal conductivity of the alumina (aluminum oxide) substrate was 25 W/m·K, and the three-point bending strength was 450 MPa. The thermal conductivity of the zirconia (zirconium oxide) substrate was 25 W/m K, and the three-point bending strength was 500 MPa. The thermal conductivity of the Alusil substrate was 25 W/m·K, and the three-point bending strength was 550 MPa. A fiber laser having a wavelength of 0.1 µm (rounded to the first decimal place) was used to form the notched portion 2.

**[Table 1]**

| | Ceramic substrate type | Ceramic substrate thickness |
|---|---|---|
| Example1 | Silicon nitride substrate | 0.32mm |
| Example2 | Aluminum nitride substrate | 0.32mm |
| Example3 | Zirconia substrate | 0.64mm |
| Example4 | Silicon nitride substrate | 0.64mm |
| Example5 | Alusil substrate | 0.64mm |
| Example6 | Aluminum nitride substrate | 0.64mm |
| Comparative example1 | Alumina substrate | 0.64mm |
| Comparative example2 | Alumina substrate | 0.64mm |

Table 2 shows the shape of the notched portion 2 for the examples and comparative examples according to Table 1. Table 2 shows the angle θ₁ of the opening end portion at the notched portion 2 side, the angle θ₂ of the end portion of the notched portion 2 at the non-opening portion side, the angle θ₃ of the opening end portion at the ceramic substrate 1 side, the shape of the end portion of the notched portion 2 at the non-opening portion side, the angle of the boundary portion between the chamfer portion and the opening portion, and *L₂*/*L₁.* For the angle θ₂, the examples labeled as being not less than 90 degrees had end portions of the notched portion 2 at the non-opening portion side that were rounded shapes. Also, it can be seen that for rounded shapes, the angle θ₂ is greater than 90 degrees because the inflexion point can be used as the reference point of the substrate portion.

Specifically, the angle θ₁ was the angle at the notched portion side of the opening end portion of the ceramic substrate 1, and was the angle at a location (a notched location) of the notched portion 2 where the substrate was not present. The angle θ₂ refers to the angle of the portion at the end portion P3 of the notched portion 2 at the non-opening side where the ceramic substrate 1 was not present. The angle θ₃ was the angle of the opening end portion at the side where the ceramic substrate 1 was present.

The shape of the end portion of the notched portion 2 at the non-opening side refers to the shape of a location including P3. A U-shape is labeled as a rounded shape (substantial U). A substantially trapezoidal shape is labeled as a chamfer shape. A V-shape is labeled as a substantial V. In Table 2, the angle of the boundary portion between the chamfer portion and the opening portion refers to the shape of the boundary portion between the chamfer portion and the rounded portion or the boundary between the chamfer portion and the location of the substantially-V shape. Boundary portions that had curved shapes are labeled "no boundary".

**[Table 2]**

| | Angle θ₁ | | Angle θ₂ | Angle θ₃ | | End portion shape at non-opening side | Boundary portion angle | L₂/L₁ |
|---|---|---|---|---|---|---|---|---|
| Measurement location | P1 | P2 | P3 | P1 | P2 | - | - | - |
| Example1 | 60 | 60 | Not less than 90 degrees | 120 | 120 | Rounded shape (substantial U) | 120 | 0.3 |
| Example2 | 75 | 75 | 100 | 105 | 105 | Chamfer shape | 90 | 0.35 |
| Example3 | 45 | 45 | 45 | 135 | 135 | Substantial V | No boundary | 0.4 |
| Example4 | 30 | 30 | 120 | 150 | 150 | Chamfer shape | 150 | 0.2 |
| Example5 | 85 | 90 | 45 | 95 | 90 | Substantial V | 108 | 0.3 |
| Example6 | 65 | 90 | 90 | 115 | 90 | Substantial V | 105 | 0.3 |
| Comparative example1 | 90 | 90 | Not less than 90 degrees | 90 | 90 | Rounded shape (substantial U) | No boundary | 0.4 |
| Comparative example2 | 60 | 60 | Not less than 90 degrees | 75 | 75 | Rounded shape (substantial U) | No boundary | 0.25 |

One hundred ceramic substrates 1 in which four notched portions 2 were formed were prepared for each example. Defects of the positional accuracy of the screw retaining part after fastening by screwing were measured for the ceramic substrates 1. The positional accuracy when fastening by screwing was measured for each. The examples having a positional accuracy defect rate of not more than 2% are labeled with circles. Examples having a positional accuracy defect rate greater than 2% and not more than 3% are labeled with triangles. Examples having a positional accuracy defect rate greater than 3% are labeled with "×". Also, the area occupied by the notched portions 2 was measured, and the increase amount with respect to the example 1 was measured. The increase amount was calculated by using the increase amount between the maximum value of the area occupied by the notched portions 2 among the examples and the area occupied by the notched portions 2 of the example 1 as 100. Examples having an increase amount of not less than 0 and not more than 50 are labeled with circles. Examples having an increase amount of greater than 50 and not more than 100 are labeled with triangles. The results of the increase amount are showed in Table 3. Each notched portion of which the positional accuracy defect rate of the screw retaining part and the area occupied by the notched portions increased with respect to the example 1 were counted as "1"; four hundred locations (one hundred ceramic substrates×four notched portions per ceramic substrate) were measured; and the ratios of the increase amounts were calculated. The area increase rate is a value that compares the ratio occupied by the notched shape for fixing the same size of screw to the same size of substrate.

Also, the laser patterning surface and the fracture surface of the notched portion 2 were checked for the presence or absence of cracks and breakage for four notched portions 2 per ceramic substrate 1 for one hundred ceramic substrates 1 according to each example. In other words, the presence or absence of cracks and breakage was checked for four hundred notched portions 2. Also, the presence or absence of burr exceeding the tolerance at the side surface of the notched portion 2 was checked. The occurrence rates of burr, chipping, and cracks were checked for each example.

**[Table 3]**

| | Positional accuracy defect rate | Occupied area increase rate | Burr occurrence rate (%) | Chipping occurrence rate (%) | Crack occurrence rate (%) |
|---|---|---|---|---|---|
| Example1 | ○ | ○ | 0 | 0 | 0 |
| Example2 | ○ | △ | 0.25 | 0.25 | 0.5 |
| Example3 | △ | △ | 0.75 | 0.75 | 0.5 |
| Example4 | △ | ○ | 0.75 | 0.5 | 0.5 |
| Example5 | △ | ○ | 1.0 | 1.0 | 1.0 |
| Example6 | △ | ○ | 0.5 | 0.75 | 0.5 |
| Comparative example1 | ○ | ○ | 2.0 | 1.0 | 1.25 |
| Comparative example2 | × | ○ | 0.5 | 0.25 | 0.75 |

It can be seen from Table 3 that in the ceramic substrates of the examples, the occurrence of burr, chipping, or cracks when forming the notched portions was reduced compared to conventional structures in which the end portions were right angles. Also, in the examples, the screwing can be performed with high positional accuracy when fastening by screwing. The area of the surface to which the semiconductor element can be mounted can be maintained by suppressing the increase amount for the notched portion area as well.

Table 4 is the results of measuring the arithmetic surface roughness Ra and the maximum surface roughness Rz of the notched portion side surfaces. The side surface of the notched portion 2 was a surface parallel to the substrate thickness direction of the notched portion 2. The shape of the notched portion 2 was the shape when the notched portion 2 was when viewed from above. The opening end portion was the shape of the opening portion at the side where the substrate was present.

**[Table 4]**

| | Ra(µm) | Rz(µm) | Notched portion cross section shape |
|---|---|---|---|
| Example1 | 0.5 | 1.2 | Opening portion end portion having rounded shape |
| Example2 | 1.2 | 1.7 | Opening portion end portion having chamfer shape |
| Example3 | 0.6 | 1.0 | Opening portion end portion having rounded shape |
| Example4 | 0.9 | 1.3 | Opening portion end portion having chamfer shape |
| Example5 | 0.8 | 1.5 | Opening portion end portion being right angle |
| Example6 | 0.4 | 0.7 | Opening portion having rounded shape |
| Comparative example1 | 1.8 | 2.9 | Opening portion end portion being riaht angle |
| Comparative example2 | 1.5 | 2.0 | Opening portion end portion being right angle |

It can be seen from Table 2, Table 3, and Table 4 that neither chipping nor cracking occurred when fastening by screwing for the ceramic substrates of which the angle θ₃ of the opening end portion was greater than 90 degrees. Therefore, controlling the notched portion shape even at the side surface contributes to the yield increase when fastening by screwing.

### [Reference Numeral List]

1 ceramic substrate
2 notched portion
3 through-hole
4 conductor part
5 active metal bonding layer
6 joined body
7 semiconductor element
8 bonding layer (between semiconductor element and conductor part)
9 plating film
10 semiconductor device
θ₁ notched portion angle formed of notched portion and opening portion end portions
θ₂ angle of end portion at non-opening portion side
θ₃ interior angle of substrate at notched portion end portion
θ₄ angle of boundary portion between rounded portion and opening portion, or angle of boundary portion between chamfer portion and opening portion
P1 first opening end portion
P2 second opening end portion
P3 end portion at non-opening portion side
P4 midpoint between opening end portions
P5 most distant intersection among intersections between substrate and perpendicular line drawn from midpoint between opening end portions
P6 intersection between notched portion having the opening portion and perpendicular line drawn from midpoint between opening end portions

## Claims

1. A ceramic substrate (1), comprising:
a front surface (1a) and a back surface (1b),
a notched portion (2) being provided at one or more locations,
the notched portion (2) having an opening portion (OP),
at least one angle (*θ₃*) where the ceramic substrate (1) is present when viewed from the front surface (1a) among angles of end portions of the opening portion (OP) being greater than 90 degrees.

2. The ceramic substrate (1) according to claim 1, wherein
a shape of an end portion of the notched portion (2) at a non-opening portion side is a substantially-U shape, a substantially-trapezoidal shape, or a substantially-V shape, and
when the shape of the end portion at the non-opening portion side is the substantially-V shape, an angle of the end portion at the notched portion side is not less than 70 degrees.

3. The ceramic substrate (1) according to any one of claims 1 to 2, wherein
a rounded portion or a chamfer portion is provided at a location of the notched portion (2) at a non-opening portion side.

4. The ceramic substrate (1) according to any one of claims 2 to 3, wherein
a shape of an end portion of the notched portion (2) at a non-opening portion side is a substantially-U shape.

5. The ceramic substrate (1) according to any one of claims 1 to 4, wherein
the at least one angle (*θ₃*) where the ceramic substrate (1) is present when viewed from the front surface (1a) among the angles of the end portions of the opening portion (OP) is not less than 100 degrees.

6. The ceramic substrate (1) according to any one of claims 1 to 5, wherein
a portion between an end portion of the opening portion (OP) and an end portion of the notched portion (2) at a non-opening portion side has a curved shape or a linear shape.

7. The ceramic substrate (1) according to any one of claims 1 to 5, wherein
an angle, at a side where the substrate is present, of a boundary portion between the opening portion (OP) and a location including an end portion of the notched portion (2) at a non-opening portion side is not less than 100 degrees.

8. The ceramic substrate (1) according to any one of claims 1 to 7, wherein
an arithmetic surface roughness Ra of a side surface of the notched portion (2) is not more than 1.2 µm.

9. The ceramic substrate (1) according to any one of claims 1 to 8, wherein
a maximum surface roughness Rz of a side surface of the notched portion (2) is not more than 2.0 µm.

10. The ceramic substrate (1) according to any one of claims 1 to 9, wherein
a side surface shape of the notched portion (2) includes a location open on at least one surface side.

11. The ceramic substrate (1) according to any one of claims 1 to 10, wherein
*P4* is a midpoint between two of the end portions of the notched portion (2),
*P5* is an intersection at which a perpendicular line drawn from the midpoint P4 crosses an end portion of the ceramic substrate (1) most distant to the midpoint P4,
*L₁* is a distance between the midpoint P4 and the point P5,
*P6* is an intersection between the perpendicular line and the notched portion (2) having the opening portion (OP),
*L₂* is a length of the notched portion (2) defined by a distance between the intersection P6 and the midpoint P4, and
*L₂*/*L₁* is not less than 0.1 and not more than 0.4.

12. The ceramic substrate (1) according to any one of claims 1 to 10, wherein
the ceramic substrate (1) is a nitrogen-including ceramic.

13. A joined body (6), comprising:
the ceramic substrate (1) according to any one of claims 1 to 12; and
a conductor part (4) bonded to the ceramic substrate (1).

14. The joined body (6) according to claim 13, wherein
the conductor part (4) is a copper member or an aluminum member.

15. The joined body (6) according to any one of claims 12 to 14, further comprising:
a bonding layer bonding the ceramic substrate (1) and the conductor part (4),
the bonding layer including
one or two of copper or silver, and
an active metal.

16. A semiconductor device (10), comprising:
the joined body (6) according to any one of claims 12 to 15; and
a semiconductor element (7) to which the joined body (6) is mounted.

17. A method for manufacturing a ceramic substrate (1),
the method being for forming a notched portion (2) in a ceramic substrate (1) by using a laser,
the method comprising:
forming the notched portion (2) so that a width of the notched portion (2) at an opening portion side is greater than a width of an end portion of the notched portion (2) at a non-opening portion side.

18. A method for manufacturing a ceramic circuit board, the method comprising:
bonding a conductor part (4) to the ceramic substrate (1) manufactured by the method for manufacturing the ceramic substrate (1) according to claim 17.
